Europäisches Patentamt

European Patent Office

Office européen des brevets

(11) Publication number: **0 266 069**
**A2**

## (12) EUROPEAN PATENT APPLICATION

(21) Application number: **87308736.5**

(22) Date of filing: **01.10.87**

(51) Int. Cl.4: **G03C 1/68** , G03F 7/10

(30) Priority: **01.10.86 US 914202**
**28.09.87 US 914202**

(43) Date of publication of application:
**04.05.88 Bulletin 88/18**

(84) Designated Contracting States:
**AT BE CH DE ES FR GB GR IT LI LU NL SE**

(71) Applicant: **NAPP SYSTEMS (USA) INC.**
**360 South Pacific Avenue**
**San Marcos California 92069(US)**

(72) Inventor: **Sukarai, Kiyomi**
**246 Emerald Drive, No. 402**
**Vista California 92083(US)**

(74) Representative: **Ford, Michael Frederick et al**
**MEWBURN ELLIS & CO. 2/3 Cursitor Street**
**London EC4A 1BQ(GB)**

(54) Photopolymerizable composition useful for printing plates.

(57) A photopolymerizable composition, useful for making a high speed processable photopolymer printing plate, which is processable and developable with water is described. The composition comprises at least one water-soluble, monofunctional unsaturated ethylenic monomer in an amount of from 35% to 41% by weight; at least one polyfunctional unsaturated ethylenic monomer in an amount of from 6.5% to 8.5% by weight; at least one partially saponified, water soluble polymer in an amount of from 49% to 52% by weight; at least one photoinitiator; and, optionally, a plasticiser. The composition may be used in a photopolymer printing plate which is characterized by improved processing and printing characteristics, including water development and high speed processing with water. A plate substrate having a UV reflectance ratio in the range of from about 8% to about 15% is also described.

EP 0 266 069 A2

## PHOTOPOLYMERIZABLE COMPOSITION USEFUL FOR PRINTING PLATES

The field of the invention is photopolymerizable compositions, and in particular, photopolymerizable compositions useful for the preparation of letterpress printing plates.

Water-developable photopolymerizable compositions or resins, comprising polymers, monomers, and photoinitiators are known in which the polymers are partially saponified, water soluble, polyvinyl acetate (PVA) containing both acetyl and hydroxy groups, and having a polymerization degree of about 300 to 2,000, and a saponification value of about 65 to 99 mole percent. Takimoto, et al., U.S. Patent No. 3,801,328 discloses such a water-developable photopolymerizable composition used in photopolymer printing plates. The disclosure of U.S. Patent No. 3,801,328 is hereby incorporated by reference into this specification, as if fully set forth herein.

In addition, the use in photopolymerizable compositions of water-soluble, monofunctional and polyfunctional unsaturated ethylenic monomers in conjunction with partially saponified PVA as described is known. Photopolymerization initiators such as acteophenone, benzophenone or benzoin derivatives thereof, and benzil and benzil compounds useful in photopolymerizable compounds have been described in our copending European application and also US Serial No. 908,567, entitled "Photopolymer Printing Plate with Matte Surface," which was filed on September 18, 1986 for inventors Seiji Arimatsu and Kiyomi Sakurai, the disclosure of which is also incorporated herein by reference in its entirety, and is filed with this application to be laid open herewith.

An important consideration in the newspaper production process and in other printing is the ability to make printing plates which will allow printing of large quantities of printed material within a limited time period. In order to prepare the necessary number of plates within a limited short period of time, a highly sensitive photopolymer printing plate is generally required. In addition, the ability to achieve high resolution is very important, particularly in the area of color printing. Water developable photopolymer printing plates are highly desirable for reasons for economy and safety.

To improve processing characteristics such as exposure time, relief image quality and resolution power of the photopolymer printing plate, the components making up the plates must be optimized as to both type and quantity. Photopolymer printing plates used in the letterpress printing field typically utilize a polymer, a monomer and a photoinitiator as essential components of a photopolymer, a relatively thin layer of which is exposed selectively to ultraviolet (UV) light in order to polymerize the layer in a desired printing pattern. This photopolymer layer is adhered to a dimensionally-stable support material, which may in turn have an adherent layer applied to the support material to constitute a coated substrate for the photopolymer layer. The available choice of polymer, monomer and photoinitiator components in the photopolymer is substantially restricted in view of the need to achieve the important characteristic of water developability. Other restraints also exists, as for example, with respect to the amount of photoinitiator which may be used. An increased amount of photoinitiator usually improves plate sensitivity, but also may result in reduction of relief image quality. Large amounts of initiator enable greater absorption of UV energy, and may result in excessive absorption of energy by top layers in the photopolymer, and a resultantly lower level of energy reaching the bottom layer. This may in turn result in an undercut relief image and/or plugging of reverse or shadow areas of halftone from overpolymerization of the top layer of the photopolymer. One solution proposed in this regard is to provide a double layer in the photopolymer in which the top layer has less photoinitiator and the bottom layer has more photoinitiator. This approach results in increased plate cost, both in terms of high photoinitiator cost and increased complexity of the plate production process.

The present invention relates to improved photopolymerizable compositions which demonstrate remarkably improved processing qualities and ultimate print qualities when used with letterpress printing plate techniques. In particular, the present compositions allow processing improvements including faster exposure times and faster washout of unpolymerized composition after light exposure. In addition, the invention provides for a printing plate substrate with a relatively high UV reflectance ratio that increases sensitivity while maintaining high resolution. The compositions are water-developable. These factors lead to faster overall processing times and improved efficiency. In addition, the present compositions allow better ink transfer to the printed media, both in terms of quality of ink transfer and speed of transfer. The resulting printed images exhibit improved detail including better resolution, deeper shadows, sharper images and improved tonal rendition.

The photopolymerizable compositions of the present invention comprise

(a) one or more water-soluble, monofunctional unsaturated ethylenic monomers, preferably hydroxyethyl methacrylate (HEMA), in a combined weight percent (based on the total weight of the components (a)-(d) in the composition) of from about 35% to about 41%, and most preferably of about 38%;

(b) one or more water-soluble or water-insoluble polyfunctional unsaturated ethylenic monomers, preferably the water-insoluble monomers 1,4-butanediol dimethacrylate and tripropylene glycol diacrylate, in a combined weight percent of from about 6.5% to about 8.5%, and most preferably of about 7.5%;

(c) one or more partially saponified, water soluble polymers, preferably polyvinyl acetate (PVA) polymer, in a combined weight percent of from about 49% to about 52%, and most preferably of about 50.5%; at least one of said polymers preferably having a polymerization degree of from about 200 to about 400, and most preferably of about 300, and, preferably, a second water soluble polymer having a polymerization degree of about 500 and constituting about 25% of the combined water soluble polymer content; the combined average hydrolysis value of the water soluble polymer or polymers being from about 78 mole percent to about 84 mole percent, and most preferably about 80 mole percent, with the individual water soluble polymers preferably having hydrolysis values of from about 65 mole percent to about 90 mole percent;

(d) one or more photoinitiators, preferably benzil dimethyl ketal and benzil diethyl ketal, preferably in a combined amount of from about 1.3% to about 1.7%, and most preferably of about 1.5%; and, optionally;

(e) a plasticizer.

Photopolymer printing plates having a photosensitive coating of the water-developable compositions of Takimoto, et al., U.S. Patent 3,801,328, have been used quite satisfactorily for a number of years in the newspaper industry and have received widespread acceptance. Recently, however, due to the need to print newspapers in an increasingly cost-effective manner and to respond to increasing page counts and plate usage, it has become highly desirable to be able to process greater numbers of printing plates within a limited time. The present compositions provide improved process and printing characteristics over compositions known in the art.

It has been discovered that an effective means by which to reduce exposure time is to utilize reflected UV rays to increase the UV exposure of the photopolymer, rather than to increase sensitivity itself in the photopolymer layer by, for example, increasing photoinitiator content. Indeed, it has been discovered that sensitivity of the photopolymer layer should be controlled as to be in a moderate sensitivity range, combined with a well-controlled plate substrate which suitably reflects UV radiation, in order to keep the best balance between highlight and shadow area of halftone images, achieve ideal conical relief shapes and provide a plate having overall high sensitivity and high resolution.

U.S. Patent No. 2,951,758 discusses the desirability of maintaining reflectivity of less than 35% in a non-water developable printing plate. It has been discovered in the present invention that a UV reflectance ratio of between about 8% and about 15% provides particularly good printing plate sensitivity and image resolution, particularly in combination with the photopolymer composition also described herein. Such a printing plate allows shortened exposure time while avoiding the broader, fatter and duller relief associated with excessive plate sensitivity. In addition, the relatively high reflectance utilized herein allows effective polymerization by reflected UV light, and thus avoids the overly steep relief image associated with plates having lower reflectance and lower overall sensitivity.

The ethylenic unsaturated monomer components used in the present invention, and described above as components (a) and (b), generally comprise at least one monofunctional acrylic or methacrylic ester of a lower alkanol having one or more hydroxy groups, such (but not limited to) 2-hydroxyethyl methacrylate (HEMA), 2-hydroxy ethyl acrylate, 2-hydroxy propyl acrylate, 2-hydroxy propyl methacrylate, diethylene glycol monoacrylate, diethylene glycol monomethacylate, polyethylene glycol methacrylate, and polyethylene glycol acrylate, in combination with at least one polyfunctional acrylic or methacrylic ester having two or more polymerizable unsaturated ethylenic groups. Illustrative examples of suitable polyfunctional monomers are 1,4-butanediol methacrylate, tripropyleneglycol diacrylate, tripropylene glycol dimethacrylate, ethylene glycol diacrylate, ethylene glycol dimethacrylate, diethylene glycol diacrylate, diethylene glycol dimethacrylate, tetraethylene glycol diacrylate, tetraethylene glycol diemethacrylate, polyethylene glycol diacrylate, polyethylene glycol dimethacrylate, polypropylene glycol diacrylate, polypropylene glycol dimethacrylate, 1,4-butanediol dimethacrylate, 1,6-hexanediol diacrylate, 1,6-hexanediol glycol dimethacrylate, neopentyl glycol diacrylate, neopentyl glycol dimethacrylate, trimethylolpropane triacrylate, neopentyl glycol ethoxylated diacrylate, neopentyl glycol ethoxylated dimethacrylate, trimethylol propane trimethacrylate, glycerol diacrylate, glycerol dimethacrylate, glycerol triactylate, glycerol trimethacrylate and so on. In addition, acrylamide oligomer as described in United States Patent No.

4,209,581 or United States Patent No. 4,540,649, the disclosure of which are hereby incorporated by reference, is also available as a polyfunctional polymerizable unsaturated ethylenic group.

The preferred amount of water-soluble, monofunctional unsaturated ethylenic monomers described above as component (a) in the compositions of the present invention, as measured by weight percent of the total weight of components (a)-(d) in the composition, will be from about 35% to about 41%, and most preferably about 38%. Although this range is optimum, satisfactory results may also be achieved by using from about 30% to about 41% of monofunctional monomers. A preferred monofunctional monomer is HEMA, which has been shown to yield surprisingly good processing and printed image qualities when used in association with the other elements of the claimed compositions as described herein. An important aspect of the present invention is the weight percent of each of the components in the claimed compositions, for it has been shown that the particular weight percents described will yield compositions having remarkable improvements as described above.

The water-soluble or water-insoluble polyfunctional unsaturated ethylenic monomers described above as component (b) will be present as single monomers or as mixtures of monomers. In one preferred embodiment of the invention, the water-insoluble monomers 1,4-butanediol dimethacrylate and tripropylene glycol diacrylate are used in combination in a total amount by weight of from about 6.5% to about 8.5%, with the preferred amount being about 7.5%. This is an optimum range, and satisfactory results may also be achieved by using from about 5% to 10% of polyfunctional monomer. A suitable combination of these monomers will be equal amounts of each, although variation in their relative amounts may be used. It is thought that use of such monomers in the total amount described contributes to the faster exposure time characteristic of the present combinations. This exposure time has been seen to be approximately 10 to 15% faster than exposure time for photopolymerizable compositions known to the art. In addition, the polyfunctional monomers described, and their respective amounts, are felt to contribute to the improved print results seen with the present compositions.

The partially saponified, water soluble polymers described as component (c) above may comprise a variety of polymers known in the art to be suitable in photopolymerizable compositions used with letterpress printing plates. One such well-known polymer is polyvinyl acetate (PVA), which is preferred for use in the present compositions. The partially saponified, water soluble polymers are preferably used in a combined weight percent of from about 49% to about 52%, and most preferably about 50.5%. Although this range is optimum, satisfactory results may also be achieved by using from about 47.5% to about 63% of water soluble polymer. It has been discovered that PVA having a polymerization degree of from about 200 to about 400 is particularly preferred, and yields performance improvements as compared to PVA having polymerization values outside of this range. A value of about 300 is especially preferred. In addition, it is preferred that PVA having a polymerization value of about 300 be utilized in conjunction with a lesser amount of PVA having a polymerization value of about 500, these two components being used in a ratio of about 3:1. Moreover, PVA having a combined average hydrolysis value of from about 78 mole percent to about 84 mole percent, and most preferably about 80 mole percent, with the individual polymers preferably having hydrolysis values of from about 65 mole percent to about 90 mole percent, will yield a particularly improved composition. In particular, PVA having a hydrolysis value in this range will allow faster washout of unpolymerized composition after light exposure of the composition in the printing process, thus speeding the processing time and adding to overall efficiency. This improvement is thought to be on the order of approximately 10 to 15%

Photoinitiators suitable for use in this invention are benzoin and derivatives thereof, as for example, benzoin alkyl ethers such as benzoin methyl ether, benzoin ethyl ether, benzoin propyl ether, benzoin isopropyl ether, and benzoin butyl ether, benzil, and benzil compounds, e.g., benzil dimethyl ketal, benzil diethyl ketal and acyl phosphineoxide. Particularly preferred photoinitiators are benzil dimethyl ketal and benzil diethyl ketal used in combination in a combined amount of from about 1.3% to about 1.7% by weight. It is thought that this range yields optimum results when used in the compositions described herein, with a total amount of about 1.5% being preferred for the benzil dimethyl ketal/benzil diethyl ketal combination. Although this range appears optimum, satisfactory results may also be achieved by using even broader ranges of photoinitiator, preferably about 1.0% to about 2.0%. A ratio of 3 parts benzil dimethyl ketal to 2 parts benzil diethyl ketal is suitable in such a combination. The exposure time required in using the described compositions has been seen to be approximately 10 to 15% faster than in other photopolymerizable compositions known in the art, which is in part attributable to the use of photoinitiators in combination with the other components described herein.

The plasticizer components given as item (e) above may be used in varying amounts, depending on the degree of hardness desired in the cured photopolymerizable composition. As a general rule, a minimum amount of plasticizer to yield a useful hardness modification of the composition would be approximately 3% by weight of the total weight of polymer component in the composition. An approximate maximum amount of plasticizer would be about 15% by weight of the total weight of polymer component. Plasticizers useful in the present invention include polyethoxylated glycerols, polyethylene glycol, and glycerol. Other plasticizers are well known and may be used successfully in the composition of the present invention.

The photopolymer composition is formed in the manner known by those skilled in the art, such as described in U.S. Patent 3,801,328. Thus, for example, where the polymer component is a partially saponified polyvinyl acetate, a mixture of the partially saponified polyvinyl acetate and water is prepared and kneaded at a temperature of about 90 to 95°C for approximately one-half hour. The amount of water used in this step may vary, but an amount of water equal to about 63% by weight of the amount of water soluble polymer (e.g., PVA) used is satisfactory. Water is used as a solvent in the preparation of the present photopolymer composition because it is a good solvent for partially saponified polyvinyl acetate and excess water can be eliminated from the plate by oven drying after the composition has been applied to the plate. After kneading, the temperature is lowered to approximately 60°C, and a mixture of monomers and photopolymerization initiator is added to the PVA-water mixture. If a thermal inhibitor is utilized, it will be included in the monomer-initiator mixture. An appropriate thermal inhibitor is about 0.16% by weight of 2,4,6-di-tert-butyl-paracresol, measured with respect to the amount of water soluble polymer (e.g., PVA) in the mixture. The monomer-initiator-inhibitor components may thus be added to the PVA-water mixture over a period of approximately one-half hour, after which the photopolymerizable composition will be cast on to a dimensionally stable substrate such as a printing plate. Preferred substrates include aluminum or steel plates. The photopolymerizable or photosensitive surface layer will have a thickness within the range of about 0.010 inches to about 0.050 inches, preferably about 0.015 to about 0.040 inches, after volatile materials are eliminated.

As described in Takimoto, et al., U.S. Patent 3,801,328, and as is well-known in the art, when a printing plate is prepared, the photopolymerizable composition is applied to one surface of a supporting substrate, typically an aluminum or other metallic plate or a plastic substrate, and subsequently exposed to actinic light, such as ultraviolet light, through a negative film, to yield the desired image. The exposed areas polymerize and harden, while the unexposed areas remain unpolymerized and hence are capable of being removed from the substrate surface by "washing" or "developing" with water.

It should be noted that the relative amounts of the individual components of the compositions described herein may change upon processing of the compositions. For example, after water is added to the composition and the resulting resin is applied to a printing plate and heated to dry the material, evaporation of water and other volatile elements in the composition may change the final relative amounts of the starting components. Thus, the improved processing and printing characteristics of the present compositions will depend not only on the starting component ratios, but on the component ratios appearing on completed, composition-treated printing plates as well. The present invention contemplates that printing plates prepared using the composition described herein will typically be dried after application of the composition, and it is intended that such dried plates also form a part of the present invention.

It has been discovered that the processing and printing characteristics of the present compositions may be enhanced by appropriate selection of a substrate for the final printing plate. Thus, it has been found that exposure time may be quickened even further by selection of a substrate having a relatively high UV reflectance ratio, preferably a reflectance ratio in the range of from about 8% to about 15%. A reflectance ratio of about 12% to 13% is particularly preferred.

The influence of UV light reflected by the substrate in relief image depends on the photopolymer printing layer thickness. In a thicker layers, reflection may be ignored. On the other hand, a thinner layer is more affected by reflection. Therefore, the substrate described above which has a UV reflectance ratio of from about 8% to about 15% in the spectral range of 300-360 nm works most effectively with a photopolymer layer having a thickness of from about 0.014 inches to about 0.025 inches.

Reflectance may be measured using standard apparatus such as a Bausch & Lomb/Shimadzu Model 210 UV-visible spectrophotometer with a UV-200 integrating sphere sample compartment. A magnesium oxide reference standard is employed with a standard slit width of 2.0 nm.

The substrate generally consists of a metallic, dimensionally stable support and a UV light absorption layer which works also as an adherent layer between the metal support and the photopolymer layer. In order to adjust the UV reflectance ratio, the UV light absorption layer may contain a color pigment dye or UV absorber. In the case of a color pigment, the particle size, distribution and volume content are adjusted to achieve the desired optimum reflectance ratio. A suitable adherent layer may be applied by roll coating a mixture consisting of, for example 69% by weight water, 5.4% PVA, 1.6% orange pigment (e.g., Ciba-Geigy "Irgalite" Orange F-2G, 9.3% white pigment (titanium oxide), 0.7% surfactant and 15% Dow Chemical latex. The coated substrate may be oven dried to yield and adherent layer having a dried thickness of about 6 to 10 microns. Such an adherent layer is believed to afford improved adhesion of the photopolymer layer to the reflective substrate, and will also provide the desired level of reflectance.

In addition, the use of substrates having such characteristics as improved adhesion to the composition or improved finish may yield superior printing results. For example, use of a matte surface, as described in the co-pending Application Serial No. 908,567, "Photopolymer Printing Plate with Matte Surface," cited above, has been shown to yield better printing quality as described in that application.

**Claims**

1. A water developable photopolymerizable composition comprising
(a) at least one water-soluble monofunctional unsaturated ethylenic monomer in a combined weight percent of from about 35% to about 41%;
(b) at least one polyfunctional unsaturated ethylenic monomer in a combined weight percent of from about 6.5% to about 8.5%;
(c) at least one partially saponified water soluble polymer in a combined weight percent of from about 49% to about 52%; and
(d) at least one photoinitiator,
said weight percents being calculated with respect to the total weight of the components (a)-(d) in the composition.

2. The composition of claim 1 wherein said photoinitiator is present in a combined weight percent of from about 1.3% to about 1.7%.

3. The composition of claim 1 further comprising a plasticizer.

4. The composition of claim 1 wherein said monofunctional monomer is selected from the group consisting of 2-hydroxyethyl acrylate, 2-hydroxyethyl methacrylate, 2-hydroxypropyl acrylate, 2-hydroxypropyl methacrylate, diethylene glycol monocrylate and diethylene glycol monomethacrylate.

5. The composition of claim 1 wherein said polyfunctional monomer is selected from the group consisting of ethylene glycol diacrylate, ethylene glycol dimethacrylate, diethylene glycol diacrylate, diethylene glycol dimethacrylate, polyethylene glycol diacrylate, polypropylene glycol dimethacrylate, 1,4-butanediol diacrylate, 1,4-butanediol dimethacrylate, 1,6-hexanediol ethoxylated diacrylate, 1,6-hexanediol glycol ethoxylated dimethacrylate, neopentyl glycol diacrylate, neopentyl glycol dimethacrylate, trimethylol propane trimethacrylate, glycerol diacrylate, glycerol dimethacrylate, glycerol triacrylate, glycerol trimethacrylate, tripropylene glycol diacrylate, tripropylene glycol dimethacrylate and acrylamide oligomer.

6. The composition of claim 1 wherein said water soluble polymer comprises at least one polyvinyl acetate.

7. The composition of claim 6 wherein at least one said polyvinyl acetate has a polymerization degree of from about 200 to about 400 and a hydrolysis value of from about 78 mole percent to about 84 mole percent.

8. The composition of claim 6 wherein said water soluble polymer comprises about 75% of polyvinyl acetate having a polymerization degree of about 300 and about 25% of polyvinyl acetate having a polymerization degree of about 500, the combined average hydrolysis value of said polymer being from about 78 mole percent to about 84 mole percent.

9. The composition of claim 1 wherein said photoinitiator is selected from the group consisting of benzoin, benzoin alkyl ether, benzil, benzil ketals, benzil dimethyl ketal, benzil dimethyl ketal and acyl phosphineoxide.

10. The composition of claim 3 wherein said plasticizer is present in an amount equal to from about 3% of the weight of said polymer to about 15% of the weight of said polymer.

11. The composition of claim 10 wherein said plasticizer is a polyethoxylated glycerol, polyethylene glycol or glycerol.

12. A water developable photopolymerizable composition comprising
(a) hydroxyethyl methacrylate in a weight percent of from about 35% to about 41%;
(b) a mixture of 1,4-butanediol dimethacrylate and tripropylene glycol diacrylate in a combined weight percent of from about 6.5% to about 8.5%;
(c) a mixture of polyvinyl acetate in a combined weight percent of from about 49% to about 52%, said polyvinyl acetate mixture comprising about 75% of polyvinyl acetate having a polymerization degree of from about 200 to about 400 and about 25% of polyvinyl acetate having a polymerization degree of about 500, the combined average hydrolysis value of said polyvinyl acetate mixture being from about 78 mole percent to about 84 mole percent; and

(d) a mixture of benzil dimethyl ketal and benzil diethyl ketal in.a combined weight percent of from about 1.3% to about 1.7%,

said weight percents being calculated with respect to the total weight of the components (a)-(d) in the composition.

13. A plate capable of being adapted for use in printing newspapers, comprising a substrate having disposed on one surface thereof the photopolymerizable composition of any one of the preceding claims.

14. The plate of Claim 13 wherein said composition is in a dried form.

15. The plate of Claim 13 or Claim 14 wherein the UV reflectance ratio of said substrate is from about 8% to about 15%.

16. The plate of Claim 15 wherein said UV reflectance ratio is about 12% to 13%.

17. A plate capable of being adapted for use in printing newspapers, comprising a substrate having a UV reflectance ratio of from about 8% to about 15% and, disposed on one surface of said substrate, a water developable photopolymerizable composition comprising

(a) at least one water-soluble monofunctional unsaturated ethylenic monomer;

(b) at least one polyfunctional unsaturated ethylenic monomer;

(c) at least one partially saponified water soluble polymer; and

(d) at least one photoinitiator.

18. The plate of Claim 17 wherein said composition is in a dried form.